# EUROPEAN PATENT APPLICATION

(11) **EP 4 318 577 A1**
(43) Date of publication of application: **07.02.2024**
(21) Application number: 22187990.1
(22) Date of filing: 31.07.2022
(51) Int. Cl.: H01L 23/495

(54) **CLIP STRUCTURE FOR A PACKAGED SEMICONDUCTOR DEVICE**

(71) Applicant: Nexperia B.V., 6534 AB Nijmegen (NL)
(72) Inventor: Ting, Jia Yunn, Seremban (MY); Chang, Ting Wei, Seremban (MY); Wing Onn, Chaw, Seremban (MY)
(74) Representative: Pjanovic, Ilija

(57) **Abstract**

A clip structure for a packaged semiconductor device. The packaged semiconductor device comprises a first die portion and a second die portion being electrically isolated from the first die portion. The clip structure comprises a first portion, a second portion and a gate wire bond. The first portion is electrically conductive, and the first portion is configured to integrally connect a source terminal with the first die portion. The second portion is electrically conductive and is electrically isolated from the first portion, and is configured to connect to a gate terminal. The gate wire bond is configured to connect the second portion with the second die portion.

## Description

### TECHNICAL FIELD

The present disclosure generally relates to packaged semiconductor devices. Particular embodiments relate to a clip structure for a packaged semiconductor device, a packaged semiconductor device, and a method of manufacturing a packaged semiconductor device.

### BACKGROUND

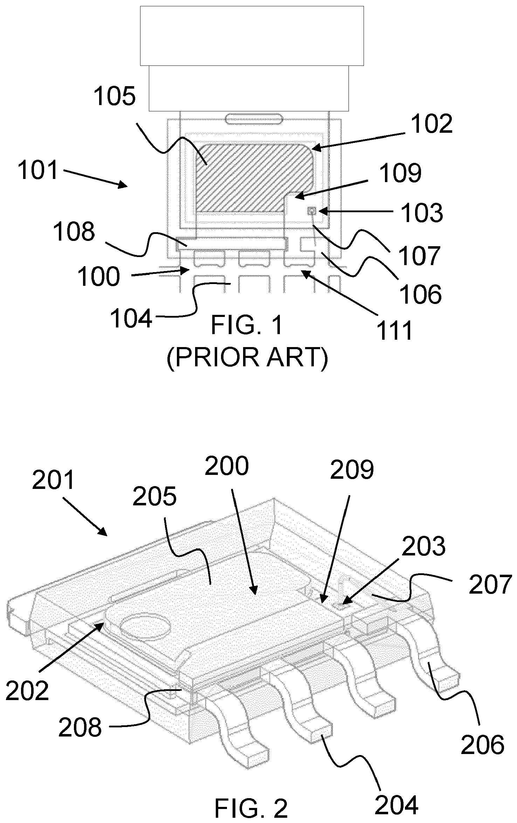

Pw-MOSFET (Power MOSFET, Metal Oxide Semiconductor Field Effect Transistor) packaging resistance is affected by source contact area on the die. Maximizing this contact area can improve current density, can reduce the package resistance, and can thus improve package performance. A drawback of conventional clip structures (e.g. shown in Figures 1 and 2) is that the source bond pad opening (BPO) size is limited. A larger gate bond pad opening is desirable for a gate clip interconnector of more than 500 um due to stamp clip fabrication limitations, compared to a gate wire bond as used in other conventional clip structures where the bond pad size can be reduced to less than 200 um, depending on wire size (typically in the range of 30 to 50 um for Au/Cu wire size). Besides, with the same 5x6 package footprint, this conventional clip structure has the disadvantage of requiring an additional solder joint at the lead, and has the limitation of a smaller die size which results in a smaller source clip contact area due to more package area being needed for the lead design.

### SUMMARY

It is an aim of at least some embodiments according to the present disclosure to improve or reduce package resistance performance.

In a first aspect of the present disclosure, there is provided a clip structure for a packaged semiconductor device. The packaged semiconductor device comprises a first die portion and a second die portion being electrically isolated from the first die portion. The clip structure comprises a first portion, a second portion and a gate wire bond. The first portion is electrically conductive, and the first portion is configured to integrally connect a source terminal with the first die portion. The second portion is electrically conductive and is electrically isolated from the first portion, and is configured to connect to a gate terminal. The gate wire bond (which may also be called an interconnect) is configured to connect the second portion with the second die portion.

In this way, the combination of the integral connection on the one hand by the first portion and the gate wire bond on the other hand ensures that only a relatively modest free area is required around the second die portion. As the free area can be reduced in comparison to a conventional clip structure, the total contact area between the first die portion and the first portion can be increased, which reduces the overall package resistance of the packaged semiconductor device, and thus improves performance. In other words, by the combination of an integral (which may also be called continuous) clip structure and the gate wire bond it is made possible to maximize the pad size. In this way, a larger contact area of the clip structure can be designed, which allows to increase the total contact area. This in turn reduces package resistance and thus allows to improve package performance.

In an embodiment, the first portion comprises an integrally shaped leadframe providing a single-material electrical conduction channel, in order to integrally connect the source terminal with the first die portion. In this context, the leadframe is a conductive heatslug configured to connect to the die of the packaged semiconductor device via a conductive die attach adhesive material, e.g. solder.

In an embodiment, the gate wire bond comprises a wire thread having a length of less than 1 mm, preferably around 0.5 mm.

In an embodiment, the gate wire bond extends substantially perpendicularly away from the second die portion over at least a part of the length of the gate wire bond.

In an embodiment, the first portion comprises a body portion configured to connect with the first die portion; and a finger portion comprising a plurality of elongated extensions extending away from the body portion and configured to connect with the source terminal.

In a further developed embodiment, the finger portion comprises at least one arched recess separating neighbouring elongated extensions of the plurality of elongated extensions.

In a yet further developed embodiment, the at least one arched recess is defined in a region of the finger portion adjacent to the body portion.

In another embodiment, each elongated extension of the plurality of elongated extensions has an S-shaped lengthwise cross-section in order to bridge a level difference between the source terminal and the body portion.

In an embodiment, the second portion comprises an at least partially elongated extension extending away from the second die portion and having an S-shaped lengthwise cross-section in order to bridge a level difference between the gate terminal and the second die portion.

In an embodiment, the at least partially elongated extension has a hammer-shaped end facing the gate wire bond.

In a second aspect of the present disclosure, there is provided a packaged semiconductor device comprising: a first die portion; a second die portion, wherein the second die portion is electrically isolated from the first die portion; and a clip structure according to any preceding embodiment, wherein the clip structure is arranged such that the first portion of the clip structure integrally connects a source terminal with the first die portion and such that the gate wire bond connects the second portion of the clip structure with the second die portion.

In a third aspect of the present disclosure, there is provided a method of manufacturing a packaged semiconductor device. The method comprises the following steps. Providing a bottom frame or a conductive heat slug. Dispensing a first screen of conductive die attach adhesive on the bottom frame or conductive heat slug. Attaching a silicon die comprising a first die portion defining a source bond pad and a second die portion defining a gate bond pad on the first screen. Dispensing a second screen of conductive die attach adhesive on the first die portion. Placing a clip structure according to any one of the above-described clip structure embodiments, the clip structure having a first portion, a second portion and a gate wire bond, such that the first portion of the clip structure is placed on the second screen and the second portion of the clip structure is placed near the second die portion. The step of placing the clip structure comprises a step of disposing the gate wire bond of the clip structure to connect the second portion of the clip structure with the second die portion.

### BRIEF DESCRIPTION OF THE DRAWINGS

The above-described embodiments will be more fully understood with the help of the following illustrative description and with reference to the drawings, in which:
Figure 1 schematically illustrates a prior art clip structure for a packaged semiconductor device, in a top-down view;
Figure 2 schematically illustrates the prior art clip structure for a packaged semiconductor device, in an isometric perspective view;
Figure 3 schematically illustrates a clip structure embodiment for a packaged semiconductor device according to the present disclosure, in a top-down view;
Figure 4 schematically illustrates a clip structure embodiment for a packaged semiconductor device according to the present disclosure, in an isometric perspective view;
Figure 5 schematically illustrates a clip structure embodiment for a packaged semiconductor device according to the present disclosure, in a lateral view;
Figures 6A and 6B schematically illustrate a clip structure embodiment for a packaged semiconductor device according to the present disclosure, in two other lateral views;
Figure 7 schematically illustrates an embodiment of a method of manufacturing a packaged semiconductor device according to the present disclosure; and
Figure 8 schematically illustrates another embodiment of a method 800 of manufacturing a packaged semiconductor device according to the present disclosure.

The skilled person will appreciate that the embodiments described below are meant to illustrate the present invention, whose scope is determined by the claims, and are not intended to be interpreted in a limiting manner. In particular, where a feature is claimed in a dependent claim, it is foreseen that different embodiments may be conceived of by the skilled person falling within the ambit of the independent claims that do not include said feature. In particular, each separate feature presented herein as optional may be included in a more general embodiment independently of other optional features. Moreover, multiple optional features shown in combination in a single embodiment may be combined with each other without necessarily needing to include other optional features shown in the same single embodiment, if there is no technical necessity for the skilled person to consider those other optional features to be inextricably bound to the multiple optional features that are included.

### DETAILED DESCRIPTION

Figure 1 schematically illustrates a prior art clip structure 100 for a packaged semiconductor device 101, in a top-down view. The clip structure 100 comprises a source portion 104 and a body portion 105 disposed on a source die 102. The clip structure 100 further comprises a gate portion 106 connected to a gate die 103. Of course, the frame connecting the source portion 104 and the gate portion 106 will be disconnected at location 111 at a later point in manufacturing, e.g. with a mechanical punch. The gate portion 106 moreover comprises a gate wire bond 107 connecting the gate with the gate die 103. The clip structure 100 has a solder joint at region 108, connecting the source portion 104 and the body portion 105 (which may be called leadframes) by means of a distinct element of a different material, namely the solder. Because there needs to be room for the solder joint at region 108, this requires that the total contact area of the source die 102 and the body portion 105 is limited. This reduces the contact area between the die 102 and the body portion 105, which limits performance of the packaged semiconductor device 101.

Figure 2 shows the same prior art clip structure 200 as clip structure 100 of Figure 1, but in an isometric perspective view. The same considerations apply for clip structure 200 as do for clip structure 100.

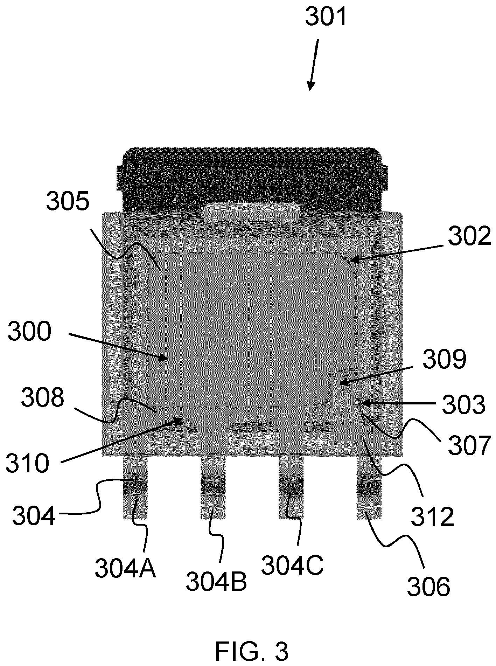

Figure 3 schematically illustrates a clip structure embodiment for a packaged semiconductor device according to the present disclosure, in a top-down view. The figure shows a clip structure 300 for a packaged semiconductor device 301. The packaged semiconductor device 301 comprises a first die portion 302 and a second die portion 303.

The first die portion 302 is indicated in a corner of the entire area covered by the first die portion 302 - it is to be understood that the angular area shown below the first portion 304, 305 (in particular below the body portion 305, as will be explained below), is the first die portion 302, and not just the indicated corner.

The second die portion 303 is electrically isolated from the first die portion 302. The second die portion 303 defines a so-called bond pad opening (BPO), which is the area of the die relating to the gate.

The clip structure 300 comprises a first portion 304, 305, a second portion 306, and a gate wire bond 307. The first portion 304, 305 is electrically conductive, and is configured to integrally connect a source terminal (not shown) with the first die portion 302. The second portion 306 is electrically conductive and is electrically isolated from the first portion 304, 305. The second portion 306 is configured to connect to a gate terminal (not shown). The gate wire bond 307, which may also be called an interconnect, is configured to connect the second portion 306 with the second die portion 303.

In the figure, a region 308 is indicated, which in embodiments according to the present disclosure is situated where a solder joint region would be situated in some conventional clip structures, for example the clip structure shown in Figures 1 and 2. As can be seen from the figure, the region 308 does not comprise a solder joint between two leadframes of the clip structure. Rather, the way the clip structure 300 is defined allows to integrally connect the source terminal (not shown) with the first die portion 302. In this context, "integrally" means that there is no intermediate distinct element present, but that the relevant element is an integral, unitary element. In practice, the presence of a solder joint as in some conventional clip structures would mean that those conventional clip structures do not allow to integrally connect their source terminal with their first die portion, since the solder joint is intermediate between the leadframes of those conventional clip structures and since the solder joint is a distinct material element. In a preferred embodiment, the first portion 304, 305 of the clip structure 300 may thus comprise an integrally shaped leadframe providing a single-material electrical conduction channel, in order to integrally connect the source terminal (not shown) with the first die portion 302.

The figure also shows how the gate wire bond 307 requires only a relatively modest free area 309 around the second die portion 303. As the free area 309 can be reduced in comparison to a conventional clip structure, the total contact area between the first die portion 302 and the first portion 304, 305 can be increased, which reduces the overall package resistance of the packaged semiconductor device 301, and thus improves performance.

The figure further shows several optional features, which are currently preferred but are not currently deemed essential and which may be included in embodiments according to the present disclosure independently of other features among these optional features.

An optional feature is that the gate wire bond 307 comprises a wire thread having a length of less than 1 mm, preferably around 0.5 mm (i.e. preferably in the range of 0.4 mm to 1 mm, preferably close to 0.5 mm). A further optional feature is that the wire thread may have a thickness of less than 20 um, e.g. 18. um. The relatively short length of the gate wire bond 307 has the advantage to better reduce the free area 309 around the second die portion 303.

Another optional feature is that the gate wire bond 307 may extend substantially perpendicularly (i.e. at an angle of or near to 90 degrees, e.g. within a range of 60 - 90 degrees) away from the second die portion 303 over at least a part (preferably over at least 10% of its overall length) of the length of the gate wire bond 307. This has the advantage that, as the gate wire bond 307 extends away perpendicularly, thus as straight or nearly as straight as possible, less room is needed for the gate wire bond 307 to reach the level of the second die portion 303, and therefore the available free area 309 is further improved. It is noted that this is not the case for a gate wire bond which would contact the second die portion from a shallow angle, even though of course from a microscopic point of view such a gate wire bond would extend perpendicularly away from the second die portion in the sense that its constituent atoms are stacked upwards, but that is only for a very minuscule part (certainly below 10%) of its overall length and therefore does not qualify as substantially perpendicular.

Another optional feature is that the first portion 304, 305 may comprise a finger portion 304 comprising a plurality of elongated extensions 304A-C, which may also be called source pins, extending away from the rest of the first portion 304, 305 (which may be considered a body portion 305). The elongated extensions 304A-C may be configured to connect with the source terminal (not shown).

Another optional feature is that the finger portion 304 may comprise at least one arched recess 310 (in this example there are two arched recesses 310 present) separating neighbouring elongated extensions of the plurality of elongated extensions 304A-C. This has the advantage that even less space is used to form the elongated extensions 304A-C, as opposed to a block-shaped separation which would require more material at the end of the finger portion 304 near to the first die portion 301 in order to ensure structural sturdiness, thus further improving the total contact area between the first die portion 302 and the first portion 304, 305.

Preferably, the at least one arched recess 310 may be defined in a region 308 of the finger portion 304 adjacent to (i.e. close to and preferably abutting) the body portion 305.

Another optional feature is that each elongated extension of the plurality of elongated extensions 304A-C may have an S-shaped lengthwise cross-section in order to bridge a level difference between the source terminal (not shown) and the body portion 305. A further advantage of this shape is for heat behaviour as it allows better expansion/contraction through many heat cycles without structural damage, as opposed to a straight pin.

Another optional feature is that the second portion 306 may comprise an at least partially elongated extension extending away from the second die portion 303 and having an S-shaped lengthwise cross-section in order to bridge a level difference between the gate terminal (not shown) and the second die portion 303. A further advantage of this shape is for heat behaviour as it allows better expansion/contraction through many heat cycles without structural damage, as opposed to a straight pin.

Bridging a level difference in the foregoing description may be better understood as follows. The elongated extensions 304A-C and/or the at least partially elongated extension of the second portion 306 may be formed in a forming process after mould encapsulation. A goal of this forming process may be to bend the lead to become level with the heatsink. With the same level only the lead and the heatsink can be mounted to a PCB board.

Another optional feature is that the at least partially elongated extension of the second portion 306 may have a hammer-shaped (or "T"-shaped, i.e. a shape having multiple extensions extending away from a main longitudinal shaft) end 312 facing the gate wire bond 307. An advantage of this hammer shape is that the at least partially elongated extension of the second portion 306 can be better anchored within mould encapsulation material, compared to a straight pin shape, which might more easily be pulled out accidentally.

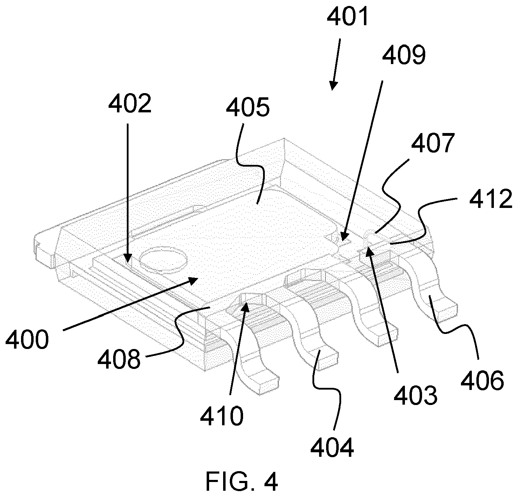

Figure 4 schematically illustrates a clip structure embodiment for a packaged semiconductor device according to the present disclosure, in an isometric perspective view.

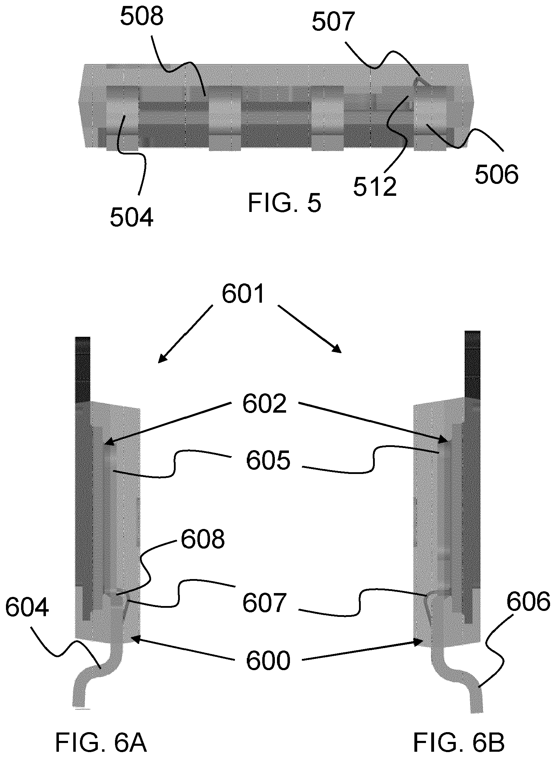

The clip structure (and the packaged semiconductor device) shown in Figure 4 may be the same embodiment as the clip structure shown in Figure 3, or it may be a further development thereof, or it may be a different embodiment altogether. The same applies for the clip structures shown in Figures 5, 6A and 6B. For this reason, similarly structured reference numbers have been used in these figures.

Figure 5 schematically illustrates a clip structure embodiment for a packaged semiconductor device according to the present disclosure, in a lateral view.

Figures 6A and 6B schematically illustrate a clip structure embodiment for a packaged semiconductor device according to the present disclosure, in two other lateral views.

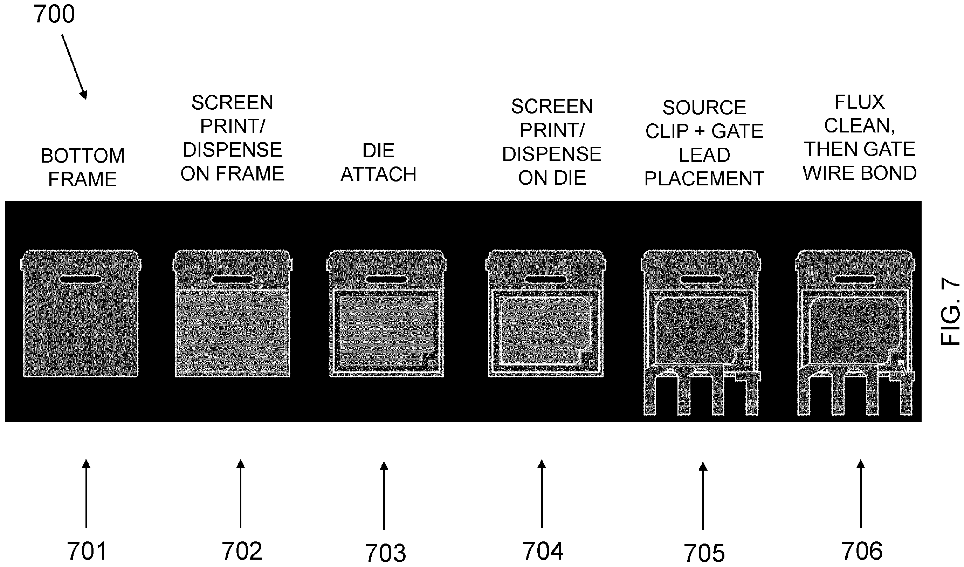

Figure 7 schematically illustrates an embodiment of a method 700 of manufacturing a packaged semiconductor device according to the present disclosure.

The method 700 comprises the following steps:
- providing 701 a bottom frame, also called a heatslug;
- dispensing 702 a first screen (which is an electrically conductive solder) on the bottom frame;
- attaching 703 a first die portion and a second die portion on the first screen;
- dispensing 704 a second screen (which is an electrically conductive solder) on the first die portion; and
- placing 705 a clip structure according to any one of the above-described embodiments, the clip structure having a first portion, a second portion and a gate wire bond, such that the first portion of the clip structure is placed on the second screen and the second portion of the clip structure is placed near the second die portion;
wherein the step of placing the clip structure comprises a step of disposing 706 the gate wire bond of the clip structure to connect the second portion of the clip structure with the second die portion.

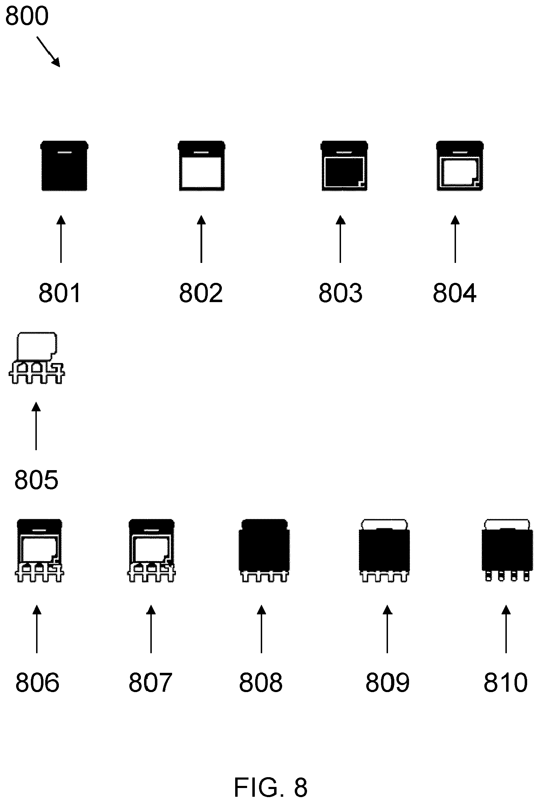

Figure 8 schematically illustrates an embodiment of a method 800 of manufacturing a packaged semiconductor device according to the present disclosure.

The method 800 comprises the following steps:
- providing 801 a bottom frame, also called a heatslug;
- dispensing 802 a conductive die attach adhesive on the bottom frame;
- attaching 803 a MOSFET die, comprising a first die portion (to be used as source) and a second die portion (to be used as gate);
- dispensing 804 a conductive die attach adhesive on the source bond pad;
- obtaining 805 a clip structure according to the present disclosure, to be used as source clip and preferably having a gate lead, which can later be severed from the source pins;
- attaching 806 the clip structure to the result of step 804;
- disposing 807 a gate wire bond on the second die portion;
- severing the gate and source leads from each other (not shown);
- mould encapsulation 808;
- deflashing 809, which is a plating process; and
- lead isolation 810.

In various embodiments, the clip structure may be made of high copper-content material, for good electrical and heat conduction. The outline of the clip structure may be stamped from a copper metal sheet according to the designed/desired source contact area. Then, the clip structure comprising a source clip and a gate clip may go through a bending process so that the clip structure can stack on the die in the height direction. As the clip structure is shaped such that the source clip is integral with the gate lead, they will go through same stamping process, however there is no bending on the gate clip only.

In various embodiments of the clip structure and of the method according to the present disclosure, the gate wire bond may be a copper or gold wire.

### LIST OF ELEMENTS SHOWN IN THE DRAWINGS

- 100,200: clip structure
- 101, 201: packaged semiconductor device
- 102, 202: source die
- 103, 203: gate die
- 104, 204: source portion
- 105, 205: body portion
- 106, 206: gate portion
- 107, 207: gate wire bond
- 108, 208: solder joint between source portion and body portion
- 109, 209: free area
- 111: connection to be disconnected

- 300: clip structure
- 301: packaged semiconductor device
- 302: first die portion
- 303: second die portion
- 304: finger portion, part of first portion
- 304A, 304B, 304C: elongated extensions of the finger portion
- 305: body portion, part of first portion
- 306: second portion
- 307: gate wire bond
- 308: region between finger portion and body portion
- 309: free area
- 310: arched recess
- 312: hammer-shaped end
- 400: clip structure
- 401: packaged semiconductor device
- 402: first die portion
- 403: second die portion
- 404: finger portion
- 405: body portion
- 406: second portion
- 407: gate wire bond
- 408: region between finger portion and body portion
- 409: free area
- 410: arched recess
- 412: hammer-shaped end
- 504: finger portion
- 506: second portion
- 507: gate wire bond
- 508: region between finger portion and body portion
- 512: hammer-shaped end
- 600: clip structure
- 601: packaged semiconductor device
- 602: first die portion
- 604: finger portion
- 605: body portion
- 606: second portion
- 607: gate wire bond
- 608: region between finger portion and body portion
- 700: method
- 701, 702, 703, 704, 705, 706: various method steps
- 800: method
- 801, 802, 803, 804, 805, 806, 807, 808, 809, 810: various method steps

## Claims

1. A clip structure (300) for a packaged semiconductor device (301), wherein the packaged semiconductor device comprises a first die portion (302) and a second die portion (303) being electrically isolated from the first die portion, the clip structure comprising:
- a first portion (304, 305) being electrically conductive, wherein the first portion is configured to integrally connect a source terminal with the first die portion;
- a second portion (306) being electrically conductive and being electrically isolated from the first portion, configured to connect to a gate terminal; and
- a gate wire bond (307) configured to connect the second portion with the second die portion.

2. The clip structure of claim 1, wherein the first portion comprises an integrally shaped leadframe providing a single-material electrical conduction channel, in order to integrally connect the source terminal with the first die portion.

3. The clip structure of any preceding claim, wherein the gate wire bond comprises a wire thread having a length of less than 1 mm, preferably around 0.5 mm.

4. The clip structure of any preceding claim, wherein the gate wire bond extends substantially perpendicularly away from the second die portion over at least a part of the length of the gate wire bond.

5. The clip structure of any preceding claim, wherein the first portion comprises:
- a body portion (305) configured to connect with the first die portion; and
- a finger portion (304) comprising a plurality of elongated extensions (304A-C) extending away from the body portion and configured to connect with the source terminal.

6. The clip structure of claim 5, wherein the finger portion comprises at least one arched recess (310) separating neighbouring elongated extensions of the plurality of elongated extensions.

7. The clip structure of claim 6, wherein the at least one arched recess is defined in a region of the finger portion adjacent to the body portion.

8. The clip structure of any one of claims 5-7, wherein each elongated extension of the plurality of elongated extensions has an S-shaped lengthwise cross-section in order to bridge a level difference between the source terminal and the body portion.

9. The clip structure of any preceding claim, wherein the second portion comprises an at least partially elongated extension extending away from the second die portion and having an S-shaped lengthwise cross-section in order to bridge a level difference between the gate terminal and the second die portion.

10. The clip structure of claim 10, wherein the at least partially elongated extension has a hammer-shaped end (312) facing the gate wire bond.

11. A packaged semiconductor device (301) comprising:
- a first die portion (302);
- a second die portion (303), wherein the second die portion is electrically isolated from the first die portion; and
- a clip structure (300) according to any preceding claim, the clip structure having a first portion (304, 305), a second portion (306) and a gate wire bond (307), wherein the clip structure is arranged such that the first portion of the clip structure integrally connects a source terminal with the first die portion and such that the gate wire bond connects the second portion of the clip structure with the second die portion.

12. A method of manufacturing a packaged semiconductor device, the method comprising:
- providing (701) a bottom frame;
- dispensing (702) a first screen on the bottom frame;
- attaching (703) a first die portion and a second die portion on the first screen;
- dispensing (704) a second screen on the first die portion; and
- placing (705) a clip structure according to any one of claims 1-10, the clip structure having a first portion, a second portion and a gate wire bond, such that the first portion of the clip structure is placed on the second screen and the second portion of the clip structure is placed near the second die portion;
wherein the step of placing the clip structure comprises a step of disposing (706) the gate wire bond of the clip structure to connect the second portion of the clip structure with the second die portion.
